# EUROPEAN PATENT APPLICATION

(11) **EP 2 568 302 A1**
(43) Date of publication of application: **13.03.2013**
(21) Application number: 12182970.9
(22) Date of filing: 04.09.2012
(51) Int. Cl.: G01R 31/3183, G01R 31/319

(54) **Automatically generating executable code for a test sequence**

(30) Priority: 07.09.2011 US 201113226852
(71) Applicant: Auriga Measurement Systems LLC, Lowell, MA 01854 (US)
(72) Inventor: Smith, Lawrence, Plaistow, NH 03865 (US)
(74) Representative: Kuhnen & Wacker

(57) **Abstract**

In one aspect, a method includes receiving data descriptive of a flow chart representing a test sequence from a user using a graphical user interface (GUI) stored on a non-transitory machine-readable medium. The flow chart includes one or more processing blocks and at least one of the one or more of the processing blocks defines a step in the test sequence. The method also includes rendering the flow chart using the GUI; providing an editing interface for editing the flow chart on the GUI, generating; using the GUI, high level software code corresponding to the data descriptive of the flow chart and configured to implement the test sequence; storing the high level software code on the non-transitory machine-readable medium; and providing access to the high level software code for editing. At least a portion of the high level software code implements the step in the test sequence.

## Description

### BACKGROUND

Testing of electronic devices is critical for device manufacturers. By testing devices prior to shipping to their customers, defective or under-performing devices may be detected and removed. To perform such tests, device testers such as automatic test equipment (ATE) may be used to characterize and validate the performance of the electronic devices.

### SUMMARY

In one aspect, a method includes receiving data descriptive of a flow chart representing a test sequence from a user using a graphical user interface (GUI) stored on a non-transitory machine-readable medium. The flow chart includes one or more processing blocks and at least one of the one or more of the processing blocks defines a step in the test sequence. The method also includes rendering the flow chart using the GUI; providing an editing interface for editing the flow chart on the GUI, generating; using the GUI, high level software code corresponding to the data descriptive of the flow chart and configured to implement the test sequence; storing the high level software code on the non-transitory machine-readable medium; and providing access to the high level software code for editing. At least a portion of the high level software code implements the step in the test sequence.

In another aspect, an article includes a non-transitory machine-readable medium that stores executable instructions. The instructions cause a machine to receive data descriptive of a flow chart representing a test sequence from a user using a graphical user interface (GUI) stored on a non-transitory machine-readable medium; render the flow chart using the GUI; provide an editing interface for editing the flow chart on the GUI; generate, using the GUI, high level software code corresponding to the data descriptive of the flow chart and configured to implement the test sequence, wherein at least a portion of the high level software code implements the step in the test sequence; store the high level software code on the non-transitory machine-readable medium; and provide access to the high level software code for editing. The flow chart includes one or more blocks and at least one of the one or more blocks defines a step in the test sequence. At least a portion of the high level software code implements the step in the test sequence

In a further aspect, automatic test equipment, includes circuitry to receive data descriptive of a flow chart representing a test sequence from a user using a graphical user interface (GUI) stored on a non-transitory machine-readable medium; render the flow chart using the GUI; provide an editing interface for editing the flow chart on the GUI; generate, using the GUI, high level software code corresponding to the data descriptive of the flow chart and configured to implement the test sequence, wherein at least a portion of the high level software code implements the step in the test sequence; store the high level software code on the non-transitory machine-readable medium; and provide access to the high level software code for editing.

### DESCRIPTION OF THE DRAWINGS

FIG. 1 is a block diagram of an example of test environment.
FIG. 2 is a block diagram of an example of a test sequence module.
FIG. 3 is a block diagram of an example of a test flow editor.
FIGS. 4A to 4D are screenshots of a test flow editor.
FIG. 4E is a screenshot of executable code of the test sequence in FIG. 4D.
FIG. 5 is a flowchart of an example of a test sequence shown in FIG. 4D.
FIG. 6 is a flowchart of another example of a test sequence.
FIG. 7 is a flowchart of an example of a process to perform a test.

### DETAILED DESCRIPTION

Described herein are techniques to allow a user to generate executable code to test a device and to edit the executable code. In particular the user is allowed to generate a test sequence to perform a test on a device. From the test sequence the user has selected, executable code is generated corresponding to the test sequence.

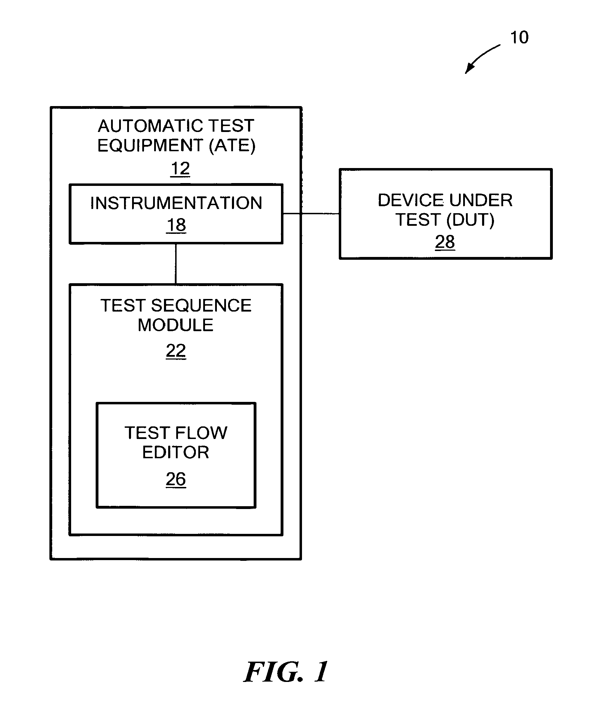

Referring to FIG. 1, a test environment 10 includes automatic test equipment (ATE) 12. The ATE 12 includes instrumentation 18 coupled to a test sequence module 22 and to a device-under-test (DUT) 28. In one example, the instrumentation 18 includes one or more instruments such as a waveform digitizer, a logic analyzer and so forth. As will be described herein the test sequence module 22 allows a user to generate executable code that will provide instructions to the instrumentation 18 to perform testing on the DUT 28. As will also be described, a test flow editor 26 of the test sequence module 22 may be used by the user to generate and edit the executable code.

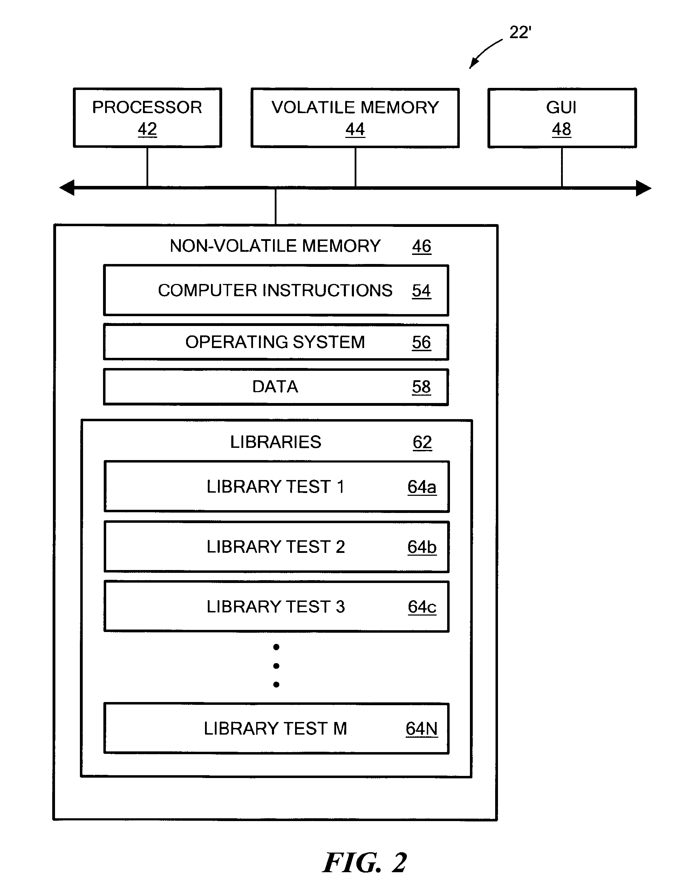

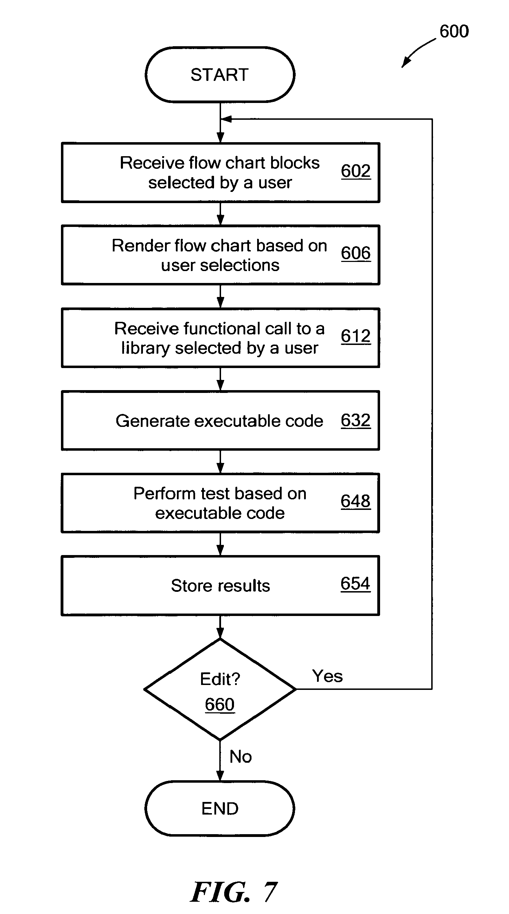

Referring to FIG. 2, one example of a test sequence module 22 is a test sequence module 22'. The test sequence module 22' includes a processor 42, a volatile memory 44, a non-volatile memory 46 (e.g., hard disk) and a graphical user interface (GUI) 48 (e.g., a keyboard, a mouse, a display, a touch screen or any combination thereof.). The non-volatile memory 46 includes an operating system 56; data 58; and computer instructions 54, which are executed out of volatile memory 44 to perform all or part of processes described herein (e.g., a process 600 (FIG. 7)). The non-volatile memory 46 also includes libraries 62 (e.g., a library test 1 64a, a library test 2 64b, a library test 3 64c, ..., a library test M 64N) used to test the DUT 28. In one example, one or more of the libraries 62 may be a dynamic link library (DLL). In one example, each of the libraries 62 performs a specific test using one or more of the instruments in the instrumentation 18.

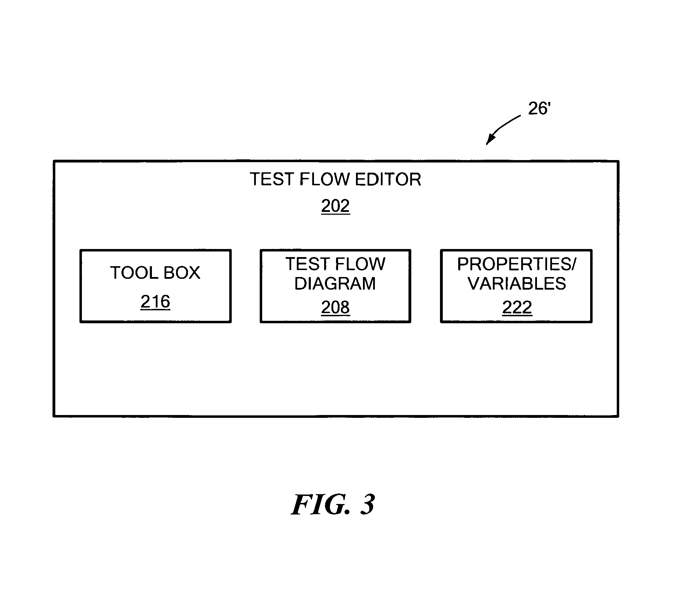

Referring to FIG. 3, one example of a test flow editor 26 is a test flow editor 26'. The test flow editor 26' includes a test flow diagram portion 208, a tool box portion 216 and a properties/variables portion 222. The user accesses the tool box portion 216 to select one or more processing blocks used to generate a test sequence that is rendered in the test flow diagram portion 208. When a processing block is selected the user will be given access to properties/variables from the properties/variables portion 222 to set the properties/variables. In one example, a processing block is one of the libraries 62.

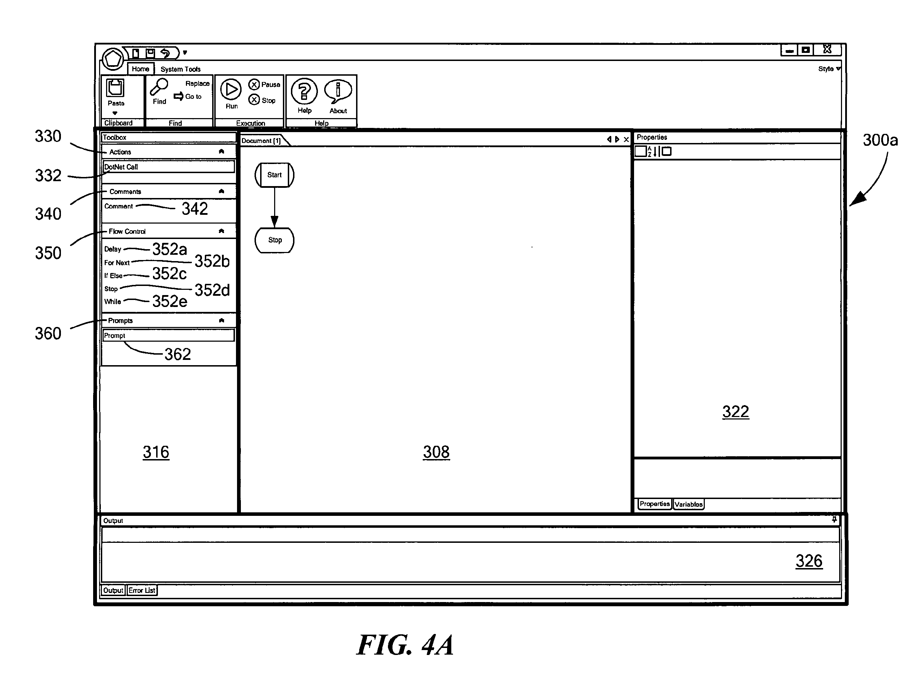

Referring to FIG. 4A, a screenshot 300a includes a toolbox window 316, a test flow diagram window 308, a properties/variables window 322 and an output window 326. The test flow diagram window 308 is part of the test flow diagram portion 208 (FIG. 3). The user forms a test sequence that is rendered as a flow chart in the test flow diagram window 308.

The tool box window 316 is part of the tool box portion 216 and is used to provide the user processing blocks for the test sequence. The tool box window 316 includes processing sections such as an actions section 330, a comments section 340, a flow control section 350 and a prompts section 360 from which the user selects the processing blocks to add to the test sequence.

For example, in the actions section 330 the user can select a command to perform a library call. In one example, a library call is DotNet call. A user may select a DotNet call by selecting a DotNet call button 332. In one example, DotNet is a type of DLL that is built on a MICROSOFT® DotNet framework. In one example, the actions section 330 shows the tabs that allow the user to open and select an external DLL call.

The flow control section 350 allows the user to control the test sequence flow by selecting a button. The flow control section 340 includes a Delay button 352a, a ForNext button 352b, a IfElse button 352c, a Stop button 352d and a While button 352e. For example, to delay the test sequence a user may select the Delay button 352a. In another example, a ForNext button 352b will loop a fixed number of times. In a further example, the While button 352e will loop while a condition is true.

The comments section 340 allows the user to generate comments by selecting a comment button 342. The prompts section 360 allows the user to have a prompt added to the test sequence by selecting the Prompt button 362. For example, by adding a prompt object to the test sequence, a Message Box will displayed on the screen at run time showing the picture and/or text entered by the user.

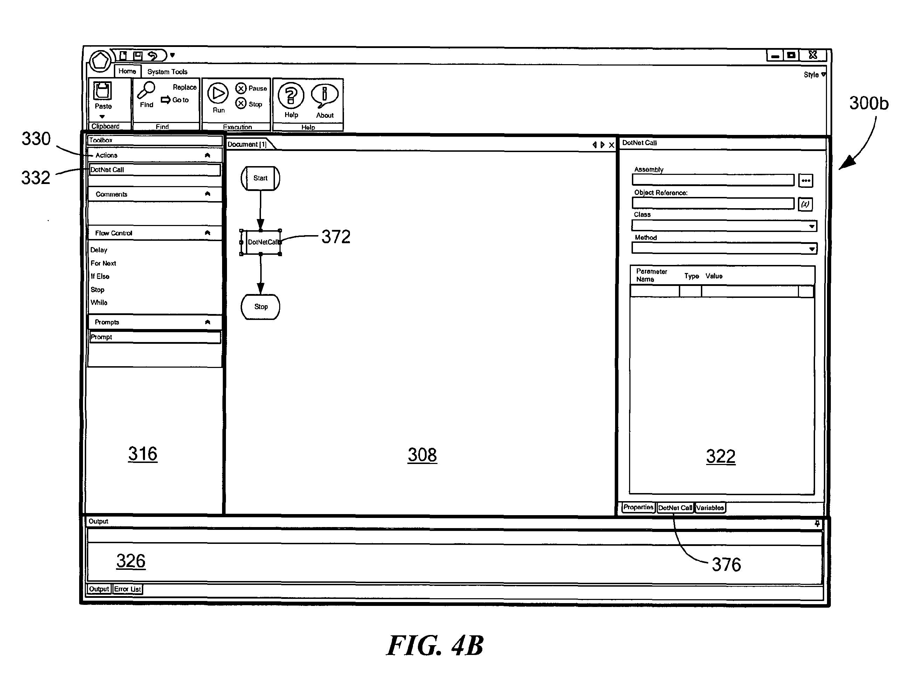

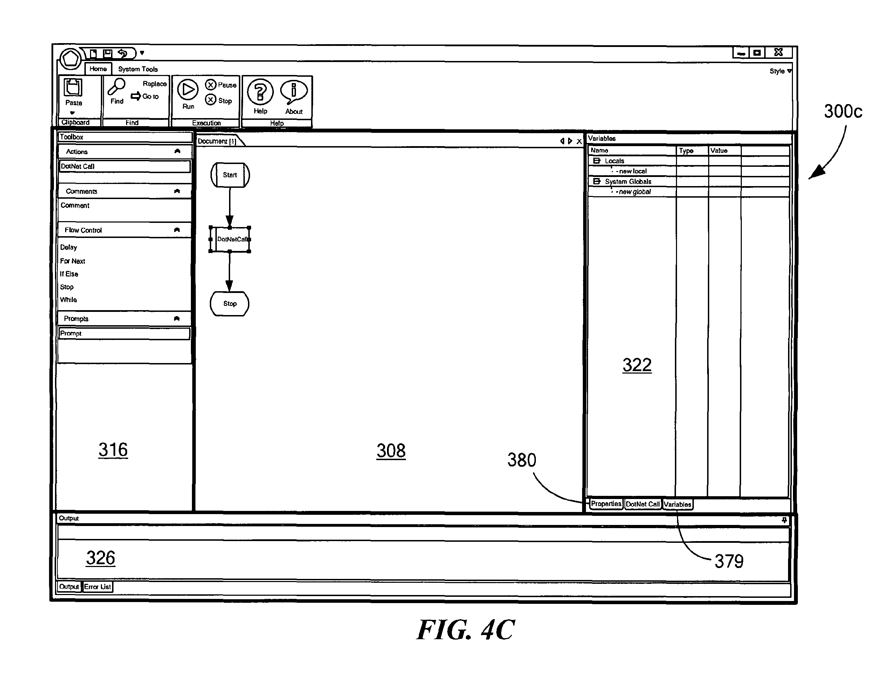

The properties/variables window 322 is included in the properties/variables portion 222. The properties/variables window 322 is used by a user to fill-in parameters of a call to a library if selected (FIG. 4B), configure properties and to add variables (FIG. 4C).

The output window 326 is used for posting messages to the user such as error messages, warnings, debug information and so forth.

Referring to FIG. 4B, a screenshot 300b is an example depicting a result of the user selecting the DotNet call button 332. In one particular example, the user moves a mouse pointer over the DotNet call button 332, clicks on the DotNet call button 332 and drags a DotNet icon 372 to the test flow diagram window 308. At the same time, a DotNet tab 376 is generated in the properties/variables window 322 to allow the user to fill in parameters, configuration information and so forth to bind it to a function call. In one example, "to bind" means to check that all of the necessary information required to make a call is available and that the call can be accessed.

Referring to FIG. 4C, a screenshot 300c is an example depicting a result of a user selecting a variables tab 378 in the properties/variables window 322. For example, local and global variables are added by the user to the test sequence for runtime data storage. The properties tab 380 is used to change the appearance of objects rendered (e.g., processing blocks displayed in test flow diagram window 308). For example, the properties tab may be used to set the color, text, font, size and so forth.

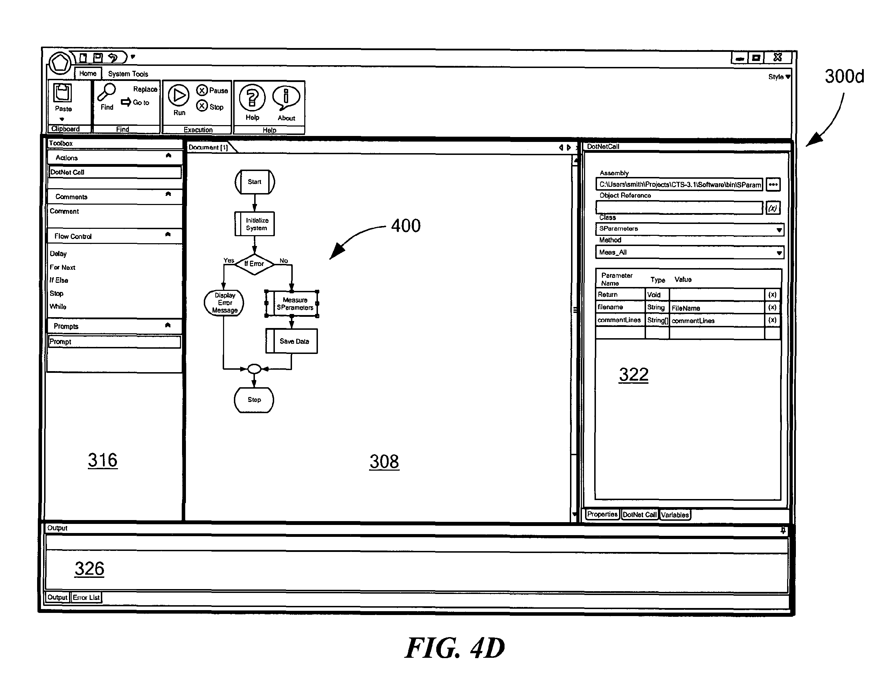

Referring to FIG. 4D, a screenshot 300d is an example depicting a result of the user forming a test sequence. In particular, a test sequence 400 is depicted in a test flow diagram window 308.

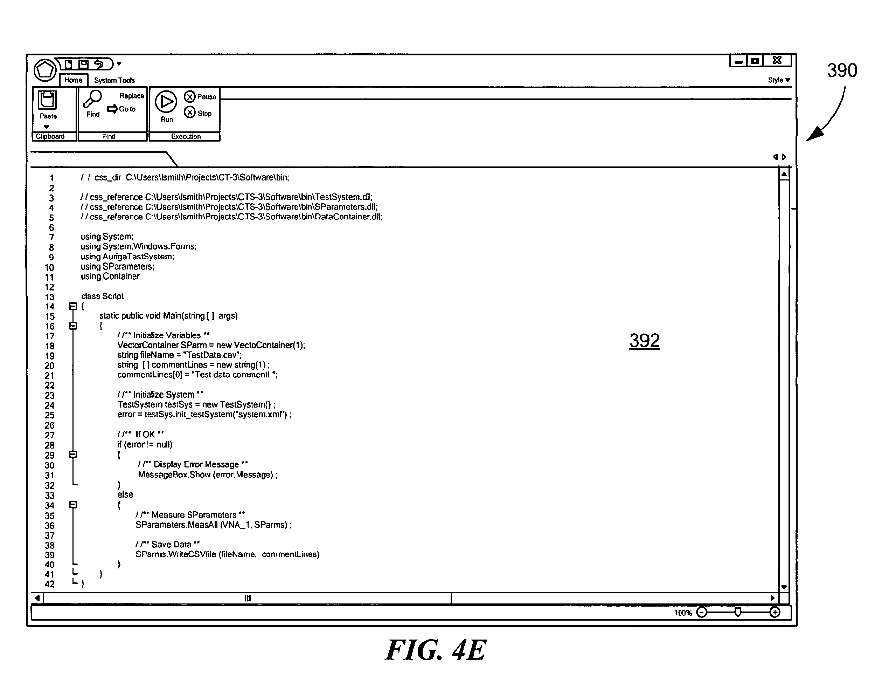

Referring to FIG. 4E, a screenshot 390 is an example of C# script generated from the test flow sequence 400 rendered in a script editor window 392. The C# script may be run in an interruptive mode, compiled into an executable code, or edited directly to improve performance and extend functionality.

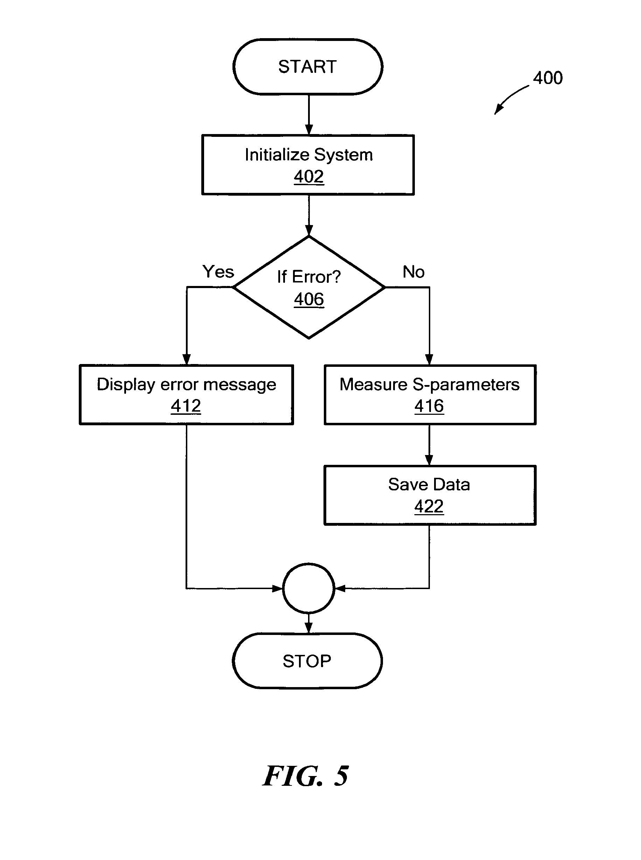

Referring to FIG. 5, the test sequence 400 depicted in FIG. 4D is shown. The test sequence 400 initializes a test system (402) and determines whether an error has occurred (406). If an error has not occurred, the test sequence 400 measures the S(scattering)-parameters of the DUT 28 (416) and saves the S-parameters of the DUT 28 (422). If there is an error, the test sequence 400 displays an error message (412).

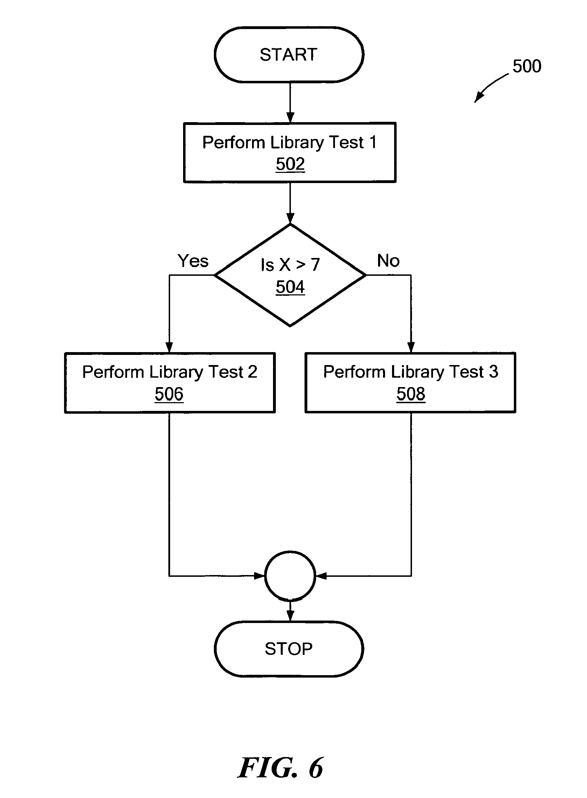

Referring to FIG. 6, another example of a test sequence is a test sequence 500. The test sequence 500 performs a library test 1 64a (502). For example, the library test 1 64a performs a test and measures a value X. For example, X may be any electrical characteristic. The test sequence 500 determines if X is above a value 7 (504) and if the value X is above a value of 7, performs the library test 2 64b. If the value X is above a value of 7, the test sequence 500 performs the library test 3 64c (508).

Referring to FIG. 7, an example of a process to generate executable code for a test sequence is a process 600. Process 600 receives flow chart blocks selected by a user (602) and renders a flow chart based on the user's selections (606). For example, a user selects processing blocks using the toolbox window 316 using the test flow editor 26.

Process 600 receives functional calls to a library (612). For example, the user using the properties/variables window 322 sets the parameters for each of the actions selected by the user.

Process 600 generates automatically (e.g., without user intervention) executable code based on the test sequence selected by the user (632), performs a test based on the executable code (649) and stores the results (654). If the user chooses to edit the test sequence (660), processing blocks 602 to 654 are repeated.

The processes described herein (e.g., the process 600) are not limited to use with the hardware and software of FIG 2; they may find applicability in any computing or processing environment and with any type of machine or set of machines that is capable of running a computer program. The processes may be implemented in hardware, software, or a combination of the two. The processes may be implemented in computer programs executed on programmable computers/machines that each includes a processor, a storage medium or other article of manufacture that is readable by the processor (including volatile and non-volatile memory and/or storage elements), at least one input device, and one or more output devices. Program code may be applied to data entered using an input device to perform one or more of the processing blocks of the process 600, for example, and to generate output information.

The processes described herein are not limited to the specific embodiments described herein. For example, the process 600 is not limited to the specific processing order of the process steps in FIG. 7. Rather, any of the processing steps of FIG. 7 may be re-ordered, combined or removed, performed in parallel or in serial, as necessary, to achieve the results set forth above. For example, editing processing block 660 may be performed after generating executable code processing block 632.

Process blocks in FIG. 7 associated with implementing the system may be performed by one or more programmable processors executing one or more computer programs to perform the functions of the system. All or part of the system may be implemented as, special purpose logic circuitry (e.g., an FPGA (field programmable gate array) and/or an ASIC (application-specific integrated circuit)).

While the invention is shown and described in conjunction with a particular embodiment having an illustrative architecture having certain components in a given order, it is understood that other embodiments well within the scope of the invention are contemplated having more and fewer components, having different types of components, and being coupled in various arrangements. Such embodiments will be readily apparent to one of ordinary skill in the art. All documents cited herein are incorporated herein by reference. Other embodiments not specifically described herein are also within the scope of the following claims.

## Claims

1. A method, comprising:
receiving data descriptive of a flow chart representing a test sequence from a user using a graphical user interface (GUI) stored on a non-transitory machine-readable medium, the flow chart comprising one or more processing blocks, wherein at least one of the one or more of the processing blocks defines a step in the test sequence;
rendering the flow chart using the GUI;
providing an editing interface for editing the flow chart on the GUI;
generating, using the GUI, high level software code corresponding to the data descriptive of the flow chart and configured to implement the test sequence, wherein at least a portion of the high level software code implements the step in the test sequence;
storing the high level software code on the non-transitory machine-readable medium; and
providing access to the high level software code for editing.

2. The method of claim 1, further comprising providing processing blocks to allow the user to select the data descriptive of the flow chart.

3. The method of claim 2 wherein receiving data descriptive of a flow chart representing comprises receiving data corresponding to a call to a library used in the test sequence selected by the user using interactive window.

4. The method of claim 3, further comprising providing to a user using the GUI a set of one or more parameters associated with the call to the library.

5. The method of claim 1 wherein receiving data descriptive of a flow chart comprises receiving data to control a flow of the test sequence selected by the user using interactive window.

6. The method of claim 1, further comprising receiving local and global variables added by the user to the test sequence for runtime data storage.

7. An article comprising:
a non-transitory machine-readable medium that stores executable instructions, the instructions causing a machine to:
receive data descriptive of a flow chart representing a test sequence from a user using a graphical user interface (GUI) stored on a non-transitory machine-readable medium, the flow chart comprising one or more processing blocks, wherein at least one of the one or more of the processing blocks defines a step in the test sequence;
render the flow chart using the GUI;
provide an editing interface for editing the flow chart on the GUI;
generate, using the GUI, high level software code corresponding to the data descriptive of the flow chart and configured to implement the test sequence, wherein at least a portion of the high level software code implements the step in the test sequence;
store the high level software code on the non-transitory machine-readable medium; and
provide access to the high level software code for editing.

8. The article of claim 7, further comprising instructions causing the machine to provide processing blocks to allow the user to select the data descriptive of the flow chart.

9. The article of claim 8 wherein the instructions causing the machine to receive data descriptive of a flow chart representing comprises instructions causing the machine to receive data corresponding to a call to a library used in the test sequence selected by the user using interactive window.

10. The article of claim 9, further comprising instructions causing the machine to provide to a user using the GUI a set of one or more parameters associated with the call to the library.

11. The article of claim 7 wherein the instructions causing the machine to receive data descriptive of a flow chart comprises instructions causing the machine to receive data to control a flow of the test sequence selected by the user using interactive window.

12. The article of claim 7, further comprising instructions causing the machine to receive local and global variables added by the user to the test sequence for runtime data storage.

13. Automatic test equipment, comprising:
circuitry to:
receive data descriptive of a flow chart representing a test sequence from a user using a graphical user interface (GUI) stored on a non-transitory machine-readable medium, the flow chart comprising one or more processing blocks, wherein at least one of the one or more of the processing blocks defines a step in the test sequence;
render the flow chart using the GUI;
provide an editing interface for editing the flow chart on the GUI;
generate, using the GUI, high level software code corresponding to the data descriptive of the flow chart and configured to implement the test sequence, wherein at least a portion of the high level software code implements the step in the test sequence;
store the high level software code on the non-transitory machine-readable medium; and
provide access to the high level software code for editing.

14. The apparatus of claim 13 wherein the circuitry comprises at least one of a processor, a memory, programmable logic and logic gates.

15. The article of claim 13, further comprising instructions circuitry to provide processing blocks to allow the user to select the data descriptive of the flow chart.

16. The apparatus of claim 15 wherein the circuitry to receive data descriptive of a flow chart representing comprises circuitry to receive data corresponding to a call to a library used in the test sequence selected by the user using interactive window.

17. The apparatus of claim 16, further comprising circuitry to provide to a user using the GUI a set of one or more parameters associated with the call to the library.

18. The apparatus of claim 13 wherein the circuitry to receive data descriptive of a flow chart comprises circuitry to receive data to control a flow of the test sequence selected by the user using interactive window.

19. The apparatus of claim 13, further comprising circuitry to receive local and global variables added by the user to the test sequence for runtime data storage.
